# EUROPEAN PATENT SPECIFICATION

(11) **EP 0 575 055 B1**
(45) Date of publication and mention of the grant of the patent: **21.11.2001**
(21) Application number: 93303925.7
(22) Date of filing: 20.05.1993
(51) Int. Cl.: C23C 14/56, C23C 14/08, C23C 14/32, C23C 14/24

(54) **Plasma vapour-deposition apparatus**
Anlage zur plasmaaktivierten Gasphasenabscheidung
Dispositif de dépôt en phase vapeur utilisant un plasma

(30) Priority: 20.05.1992 JP 12781092; 26.04.1993 JP 9988093
(43) Date of publication of application: 22.12.1993
(73) Proprietor: MURAYAMA, Yoichi, Shinjyuku-ku, Tokyo (JP); SHINCRON CO., LTD., Shinagawa-ku, Tokyo (JP); C. ITOH FINE CHEMICAL CO. LTD., Chiyoda-ku, Tokyo (JP)
(72) Inventor: Murayama, Yoichi, Shinjyuku-ku Tokyo (JP); Narita, Toshio, Shinagawa-ku Tokyo (JP)
(74) Representative: Jackson, Robert Patrick

(56) References cited:
- US-A- 3 568 632
- US-A- 5 032 421
- PATENT ABSTRACTS OF JAPAN vol. 014 no. 456 (C-0765) ,2 October 1990 & JP-A-02 182876 (ISHIKAWAJIMA HARIMA HEAVY IND CO LTD) 17 July 1990,
- PATENT ABSTRACTS OF JAPAN vol. 012 no. 198 (C-502) ,8 June 1988 & JP-A-63 000475 (TOOBI:KK;OTHERS: 02) 5 January 1988,
- PATENT ABSTRACTS OF JAPAN vol. 014 no. 265 (C-0726) ,8 June 1990 & JP-A-02 077573 (ULVAC CORP) 16 March 1990,
- PATENT ABSTRACTS OF JAPAN vol. 010 no. 327 (P-513) ,7 November 1986 & JP-A-61 133068 (MATSUSHITA ELECTRIC IND CO LTD) 20 June 1986,

## Description

The present invention relates to a plasma vapor deposition apparatus. More particularly, the present invention relates to an inline plasma vapor deposition apparatus which permits formation of a high-quality film at a high efficiency and in preferred embodiments is useful for formation of a multilayer film.

Along with the rapid development of technical innovations in such areas as electronics and optoelectronics, there has developed a need for functional thin film materials. Consequently, much research and development effort has been directed towards forming high-quality thin films and multilayer films.

For the purpose of forming such a thin films various means including vacuum vapor deposition, sputtering and plasma vapor deposition have been studied, and some of these methods have already been practically applied.

From among these methods, it is known that sputtering is excellent in terms of productivity, and high-frequency excitation. In contrast, plasma vapor deposition based on plasma excitation using coil-shaped electrodes is, on the other hand, excellent in terms of such properties as uniformity and adherence strength of the film.

According to these conventional methods, however, forming a film which is excellent in terms of quality and performance is not always compatible with achieving high productivity. It has therefore been very difficult for liquid crystal cells to be produced at a high productivity, or to form a multilayer film continuously.

The sputtering method, for example, has been defective in that it has been difficult uniformly to distribute film-forming substances on a substrate or to achieve a uniform chemical composition of a film, and pinholes and deterioration may easily be caused. Higher expectations have therefore been entertained for the method of plasma vapor deposition as described above.

In the case of the plasma vapor deposition method, however, it is necessary to take greater care than in sputtering in respect of the exciting means and vacuum evacuation which govern the formation of the plasma and handling of the vapor source materials. It has not been easy to embody such a method as a continuous process of a high productivity.

The present inventor has proposed, for example, a plasma vapor deposition apparatus having a plurality of vapor deposition sections partitioned with electromagnetic shielding plates, arranged in succession (Japanese Patent Publication No.55-21,109). Even according to this apparatus, however, it has been impossible to form a high-quality film at high efficiency. It has also been impossible to cope with the formation of a multilayer film.

With a view to solving the above-mentioned problems, the present invention provides a vacuum plasma vapor deposition apparatus which comprises a vapor source supply means, a high-frequency exciting means and a substrate holding means arranged above these means, wherein said vapor source supply means has a drive and a circular holding plate connected thereto and rotating horizontally, said circular holding plate being provided with a rotation shaft and a concentric vapor source material carrying section arranged on the surface thereof, and said high-frequency exciting means is provided with coil-shaped electrodes.

From JP-A-2182876 there is known a vacuum plasma vapor deposition apparatus comprising a vapor source supply means, a high-frequency exciting means and a substrate holding means arranged above these means, wherein said vapor source supply means has a drive and a circular holding plate connected thereto and rotates horizontally, said circular holding plate being provided with a rotation shaft and a concentric vapor source material carrying section arranged on the surface thereof.

In one aspect, the present invention is characterised in that said high-frequency exciting means is provided with coil-shaped electrodes, and in that a film thickness correcting plate is interposed between said holding plate and said substrate holding means to avoid duplication of excited particles on the surface of a substrate.

Viewed from another aspect, the invention provides a vacuum inline plasma vapor deposition apparatus comprising an inlet and an outlet for a substrate at the both ends of the apparatus line, one or more vapor deposition sections permitting independent evacuation to vacuum and evacuation sections before and after said sections, arranged in series therewith, and a transport means provided in each of the vapor deposition sections and the evacuating sections, allowing continuous passage of the substrate along a path, wherein said apparatus comprises: vapor source material supply means in which at least one vapor deposition section has a rotation shaft on a circular holding plate connected to a drive and rotating horizontally and a section for holding a vapor source material on a concentric surface, a high-frequency exciting means provided with coil-shaped electrodes below the passing substrate, and a film thickness correcting plate is interposed between said holding plate and said path to avoid duplication of excited particles on the surface of the substrate.

At least in its preferred forms, the invention provides an inline plasma vapor deposition apparatus which overcomes the above-mentioned drawbacks in the conventional technologies, permits formation of a high-quality high-performance film at a high productivity and allows formation of a multilayer film while utilizing the advantages of the plasma vapor deposition method.

Certain preferred embodiments of the invention will now be described by way of example and with reference to the accompanying drawings, in which:
Fig. 1 shows a plan view and a front view illustrating a first embodiment of the inline apparatus of the present invention;
Fig. 2 shows a perspective view illustrating the first embodiment of the inline apparatus of the present invention;
Fig. 3 shows a perspective view illustrating the first embodiment of the inline apparatus of the present invention;
Fig. 4 shows a sectional view illustrating an embodiment of the high-frequency exciting vapor deposition section;
Fig. 5 shows a plan view illustrating an embodiment of the film thickness correcting plate;
Fig. 6 shows a partial perspective view illustrating a second embodiment of the apparatus of the present invention;
Fig. 7 shows a plan view illustrating further the second embodiment of the inline apparatus of the present invention;
Fig. 8 shows a front view corresponding to Fig. 7:
Fig. 9 shows a partial perspective exterior view corresponding to Figs. 7 and 8;
Fig. 10 shows a partially cutaway perspective view corresponding to Fig. 9;
Fig. 11 shows a sectional view illustrating an embodiment of the high-frequency exiting vapor deposition section;
Fig. 12 shows a plan view illustrating an embodiment of the film thickness correcting plate; and
Fig. 13 shows a plan view illustrating a third embodiment of the inline apparatus.

The description below covers an inline apparatus as a continuous production line.

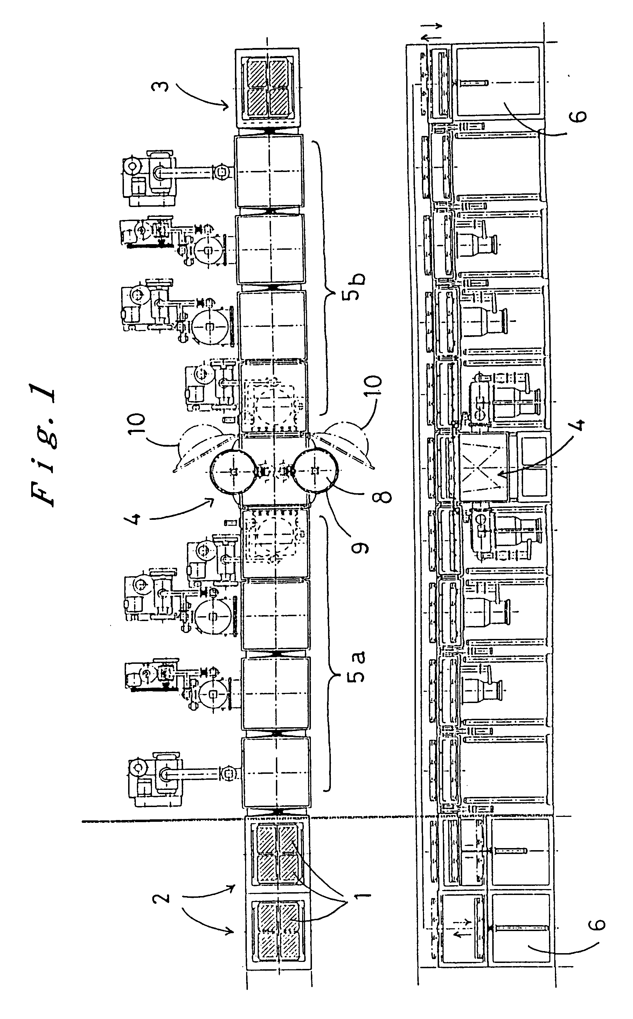

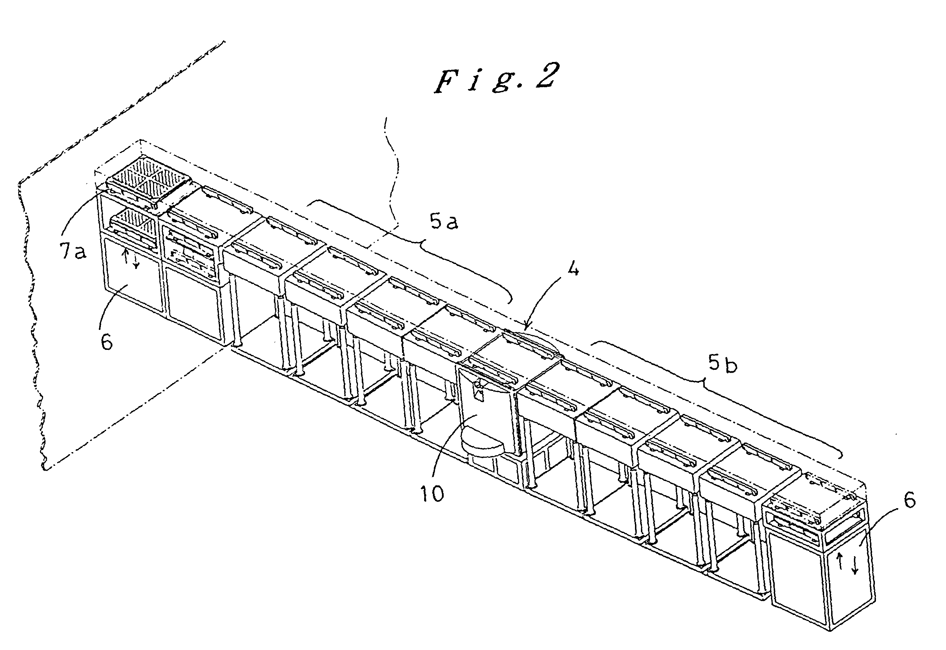

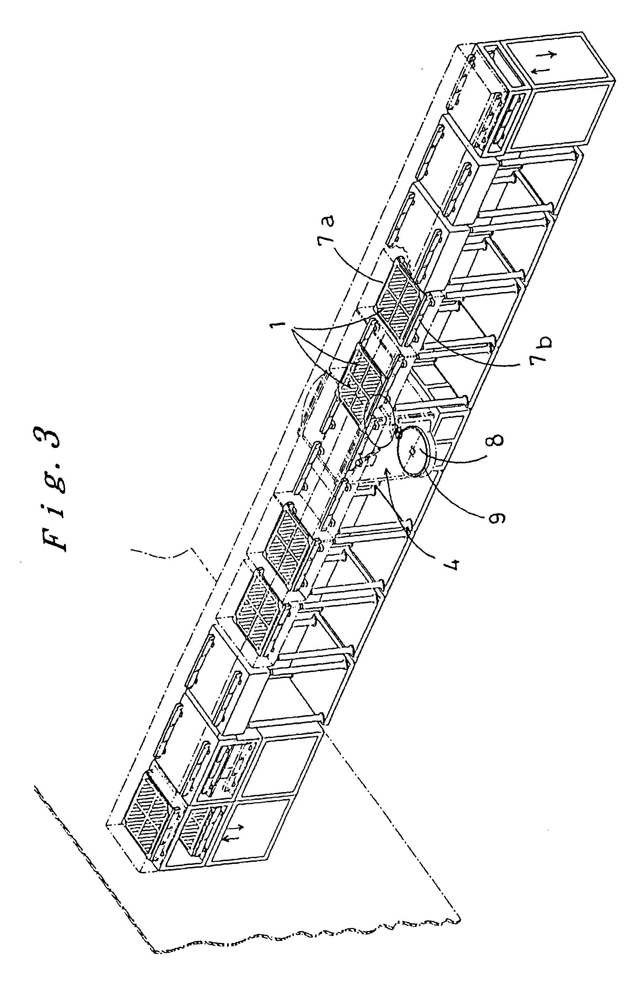

Fig. 1 includes a plan view and a front view illustrating an embodiment of the inline plasma vapor deposition apparatus of the present invention, and Fig. 2 and 3 are partially cutaway perspective views thereof. In the present invention, as shown in Figs. 1, 2 and 3, the apparatus has an inlet (2) and an outlet (3) for a substrate (1) at the both ends of the apparatus line, one or more vapor deposition sections (4) and vacuum evacuating sections (5a) and (5b) before and after the same, each permitting independent vacuum evacuation. The inlet (2) and the outlet (3) are provided with a lift mechanism (6) for the substrate (1).

The apparatus has transport means (7a) and (7b) for causing the substrate (1) continuously to pass above the vapor deposition section (4) and the vacuum evacuating section (5). Fig. 3 illustrates an example of transportation of the substrate (1). The transport means may be provided with a return mechanism.

This embodiment of the invention has a vapor source material supply means having a vapor source material (9) mounted on a horizontally rotating holding plate (8) in a vacuum chamber, at least one vapor deposition section (4), and a high-frequency exciting means provided with coil-shaped electrodes arranged below the passing substrate (1).

The substrate (1) is supported at the inlet (1) by a moving section (7a), and is transported by sliding along opposite rail sections (7b). The substrate (1) is transported through a vacuum-evacuated space in the vacuum evacuating section (5a) forming the first half of the vapor deposition section (4), and introduced into the vapor deposition section (4) under vacuum conditions. In this vapor deposition section (4), the substrate (1) is subjected to a prescribed film forming treatment, and then transported to the vacuum evacuating section (5b) forming the latter half of the section. In this case, the substrate (1) may be preliminarily heated at a prescribed point in the first half of the vacuum evacuating section (5a). The vacuum evacuating sections (5a) and (5b) form buffer sections. They connect the spaces between individual vessels with appropriate vacuum gate valves so as to allow each section including the vapor deposition sections (4) to be independently evacuated.

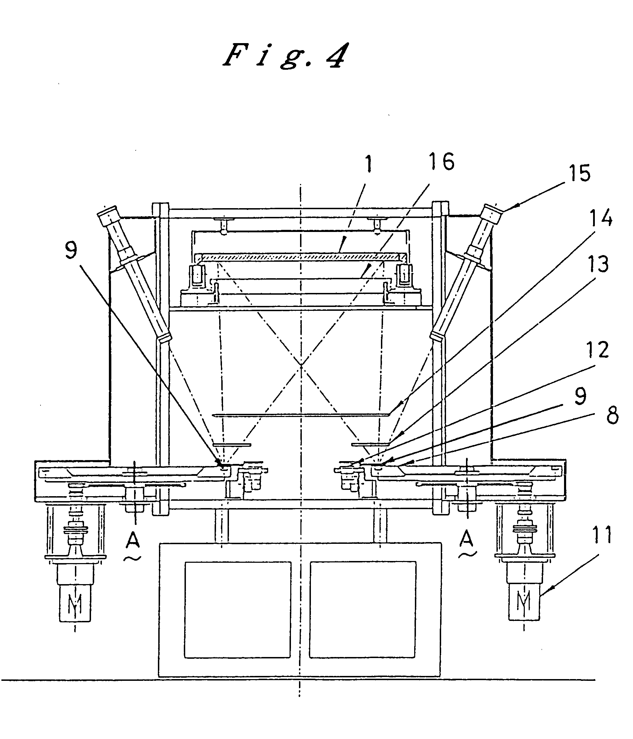

The vapor deposition section (4) is provided with a high-frequency exciting means comprising coil-shaped electrodes. As shown in Figs 1 and 2 there is also a door (10) capable of being opened and closed on the both sides of the travelling direction of the substrate (1). As shown in the sectional view given in Fig. 4 vapor source supply means, are arranged opposite each other. These have a vapor source material (9) mounted on the above-mentioned holding plate (8) at a point crossing at right angles the travelling direction of the substrate (1) passing above the same. This holding plate (8) rotates around a center axis (A) by the action of a driving means (11), so that uniform evaporation is permitted by the continuous rotation of the vapor source material (9) mounted on for example an arcuate groove of the holding plate (8). Evaporation of this vapor source material (9) is accomplished by an appropriate means such as resistance heating, induction heating, electron beam (EB) or ion beam irradiation.

In the example shown in Fig. 4, an electron beam irradiating means (12) is provided so that the vapor source material (9) is evaporated under the effect of a beam from this electron beam irradiating means (12). Evaporated particles of the material are plasma-excited by the high-frequency exciting means comprising coil-shaped electrodes (14) whilst evaporation is controlled by means of a shutter (13). This forms a film on the substrate (1) of excited ions and radicals.

By continuously evaporating the vapor source material (9) mounted on the horizontally rotating holding plate (8), and oppositely arranging the vapor source supply means at right angles to the travelling direction of the substrate (1), it is possible to achieve uniform evaporation and uniform formation of a film by plasma excitation of evaporated particles effected by the coil-shaped electrodes. This permits the achievement of uniform properties including the film structure, film thickness and adherence strength. The condition of the vapor source material (9) can be observed through a quartz monitor (15).

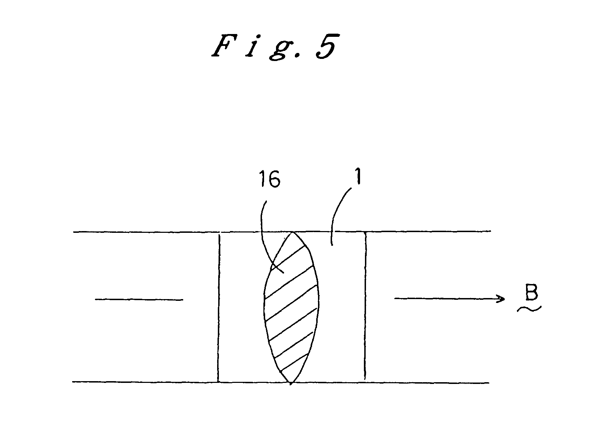

While the film is formed during the travel of the substrate (1), the above-mentioned uniformity is sufficiently ensured. With a view to further maintaining this uniformity, a film thickness correcting plate (16), is also provided on the apparatus of the present invention. This correcting plate (16) is to avoid duplication of the excited particles on the surface of the substrate (1) in order to keep a satisfactory uniformity. Usually, as shown in Fig. 5, partial shielding is effected by means of the correcting plate (16) in the travelling direction (B) of the substrate (1). The shape of the plate should preferably be variable according to the shape and arrangement of the vapor source material supply means, the kind of the vapor source material (9), and the conditions of film formation.

As to the substrate (1), it is desirable to arrange a heater (17) so as to permit heating of the substrate (1) from the back, as shown in Fig. 4.

With regard to the vapor deposition section (4), a means of applying a bias voltage to the substrate (1), and a supply means of a reactive gas and an inert gas for forming a plasma space should be arranged appropriately.

High-frequency excited plasma from the coil-shaped electrodes (14) can be generated according to various known conditions. For example, a film can be formed through plasma reaction by evaporation of any of such solid substances and metals, alloys, inorganic matters and polymers through vacuum evacuation to about 1 x 10⁻⁵ to 1 x 10⁻⁴ Torr and introduction of an inert gas such as argon or helium, and furthermore, through introduction of oxygen, nitrogen, hydrogen, hydrocarbon or a polymerizable monomer.

For example, by using ITO (indium-tin oxide) as the vapor source material, and introducing an inert gas and oxygen gas, it is for example possible to generate a high-quality ITO thin film at a high productivity level on a glass substrate. It is possible to form this film at a temperature lower than that in the conventional method such as 200 to 300°C.

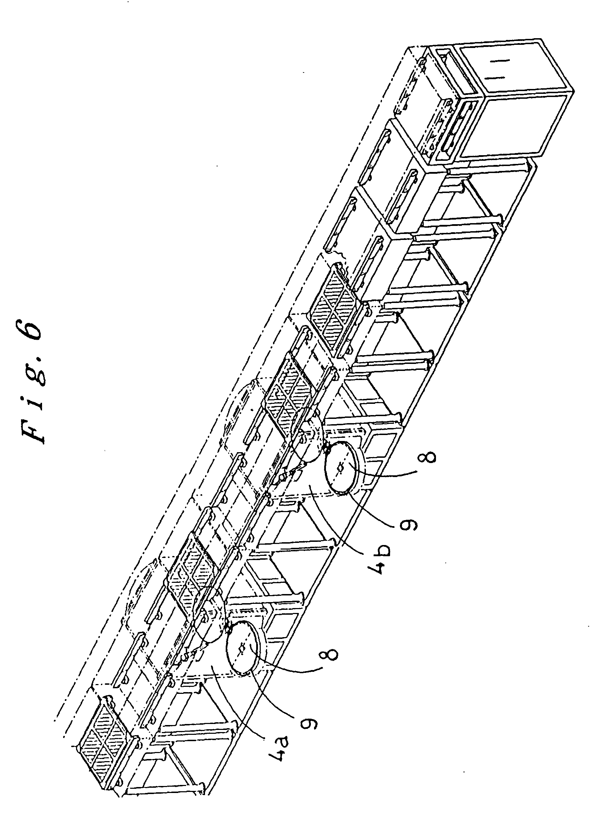

In the embodiment of the invention shown in Fig. 6, for example, it is possible to form a film of a different material, or multilayer film on prescribed portions of a masked substrate by arranging a plurality of vapor deposition sections (4a) and (4b).

With the construction as described above, a color filter substrate, for example, can be formed, after plasma vapor deposition of a metal or an inorganic matter, by plasma vapor deposition of an organic thin film, or multilayer vapor of a pigment substance. Formation of such a color filter can be accomplished continuously with the formation of an ITO film.

Ordinary vacuum vapor deposition of plasma, or a vapor deposition other than by using the coil-shaped electrode method may be combined with plasma vapor deposition.

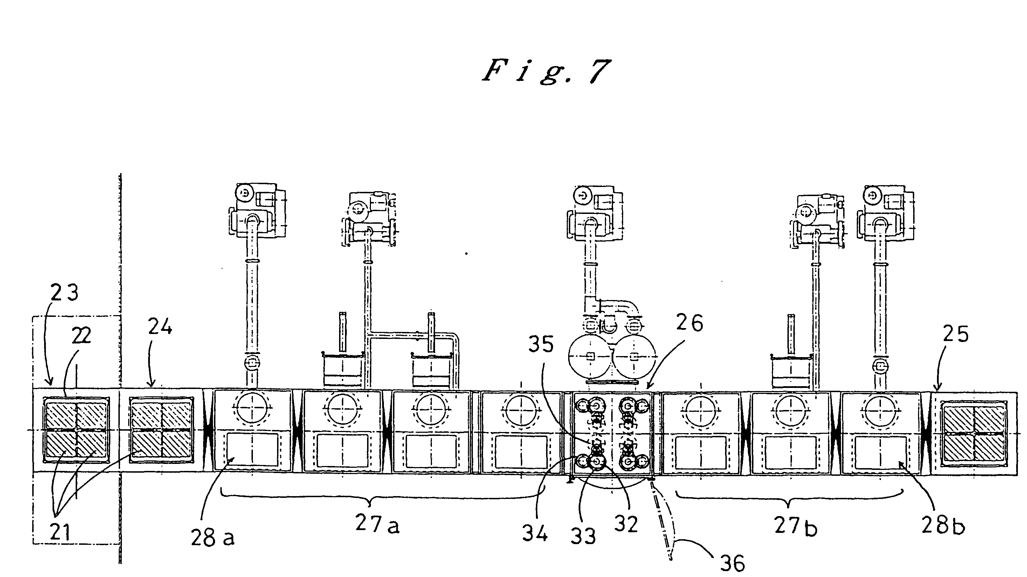

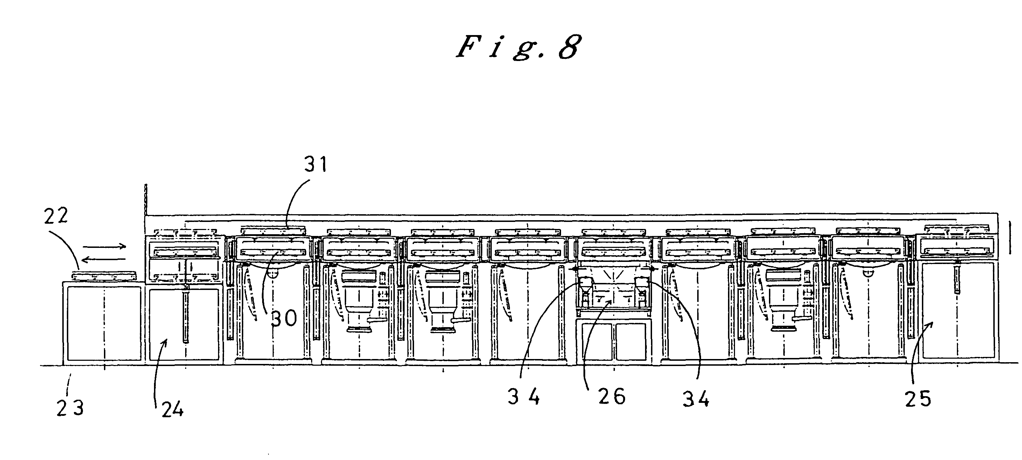

Figs. 7 and 8 illustrate another embodiment of the inline plasma vapor deposition apparatus of the present invention.

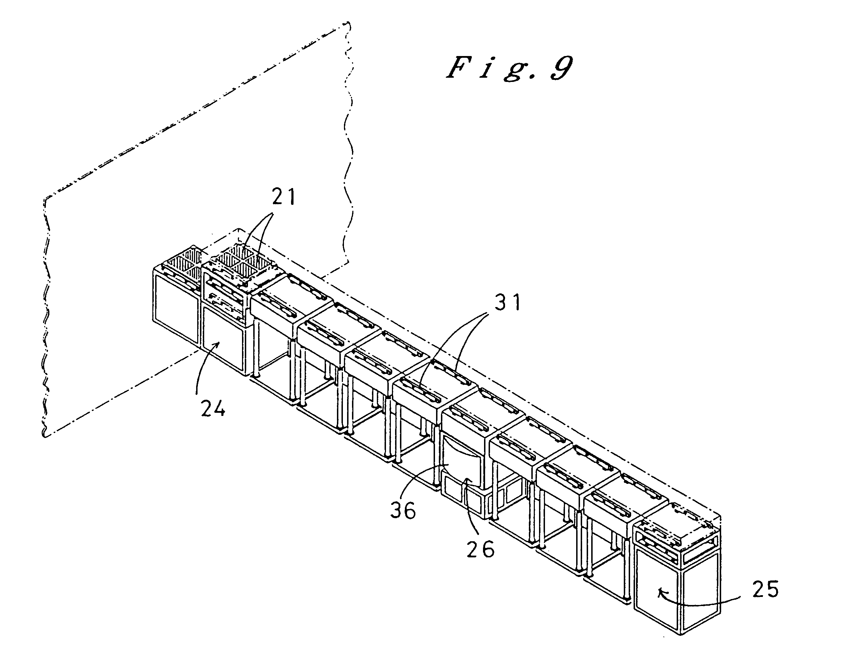

As shown in the plan view of Fig. 7 and the front view of Fig, 8, the apparatus of this embodiment has an inlet-outlet section (23) for the substrate (21) in a region partitioned from the line end of the apparatus, and pallet transport relay elevator sections (24) and (25) arranged at both ends of the line. In the middle of the line, one or more vapor deposition section(s) (26) are located which permit independent vacuum evacuation, and vacuum evacuating sections (27a) and (27b) are provided before and after the vapor deposition section(s). The apparatus is provided with a return mechanism (31), shown in Fig. 9, for taking out the transport pallet (22) (charged with the substrate (21)) from the vacuum chamber and returning the pallet (22) to the outlet section (23).

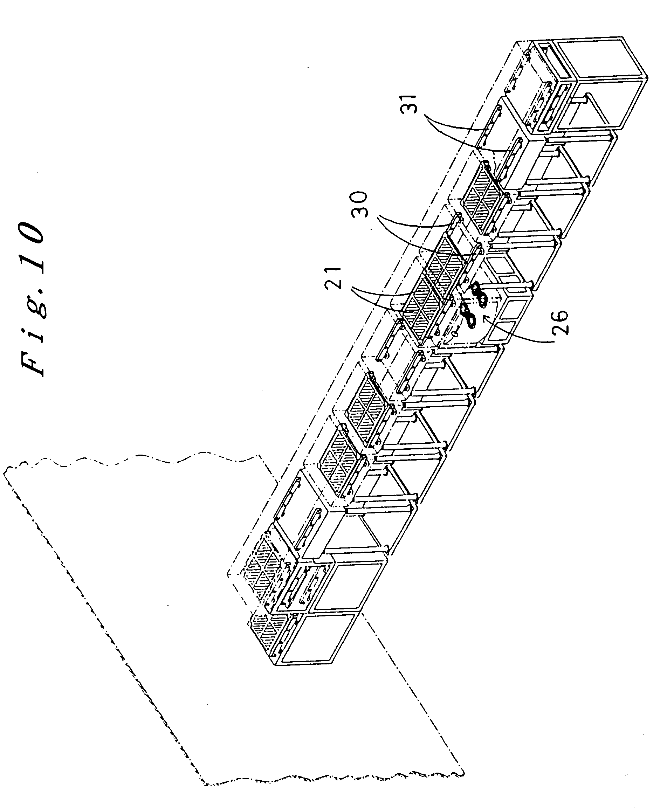

This apparatus has a transport means (30) for continuously causing the substrate (21) to pass above the vapor deposition section (26) and the vacuum evacuating sections (27a) and (27b). Fig. 10 illustrates the transportation of the substrate (21). This transport mechanism (30) has the above-mentioned return mechanism (31) in the upper region thereof.

In an inline plasma vapor deposition apparatus having the line construction as described above, a vapor source material supply means is provided. This has a vapor source material (33) on a horizontally rotating holding plate (32) in the vacuum chamber, and a high-frequency excitation means provided with coil-shaped electrodes (39) arranged below the travelling substrate (21).

The substrate (21) is charged on the transport pallet (22) at the inlet-outlet section (23), and sent to the relay elevator (24) by means of a transport mechanism (29). The substrate (21) is then transported to an inlet chamber (28a), supported by the transport mechanism (30) comprising a drive rotation mechanism and a belt drive sliding mechanism for slide transportation. The substrate (21) is transported into a vacuum-evacuated space in the vacuum evacuating section (27a) forming the first half of the vapor deposition section (26), and introduced into the vapor deposition section (26) under the vacuum conditions. In this vapor deposition section (26), the substrate (21) is subjected to a prescribed film forming treatment, and transported to the latter half of the vacuum evacuating section (27b). In this case, the substrate (21) may be preliminarily heated or subjected to a plasma treatment prior to film formation at a prescribed position in the first half of the vacuum evacuating section (27a). The vacuum evacuating sections (27a) and (27b) form a buffer space so that individual vessels including the vapor deposition section (26) are appropriately connected with vacuum gate valves in between and the vessels, can be independently vacuum-evacuated. The substrate (21) having a film formed thereon is taken out from the outlet chamber (28b) onto the pallet transport relay elevator (25) and returned by means of the return mechanism (31).

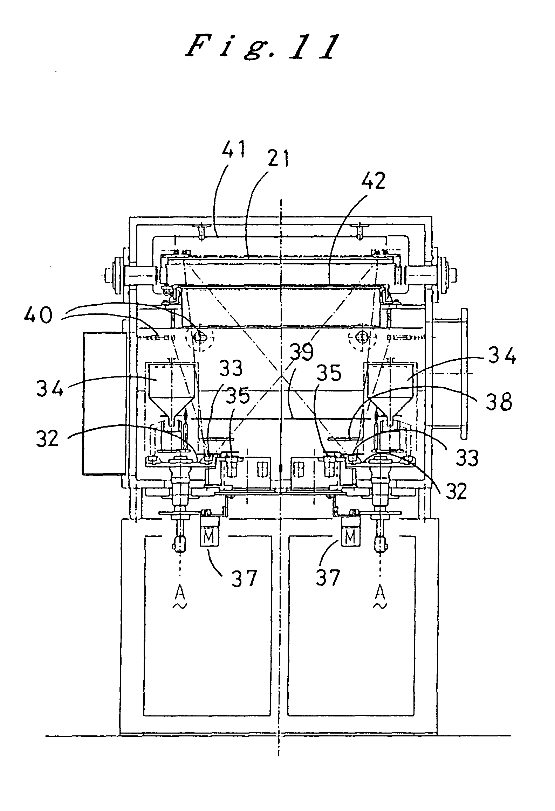

The vapor deposition section (26) has, as shown in Figs. 7 and 8 for example, a door (36) capable of being opened and closed of the side of the travelling direction of the substrate (21). It is provided, as shown in the sectional view given in Fig. 11, with a vapor source supply means having the above-mentioned holding plates (32) rotating horizontally. These are oppositely arranged and carry the vapor source material (33) at a position substantially perpendicularly to the travelling direction of the substrate (21) passing above the same. There is also a replenishing mechanism (34) for the vapor source material (34). The holding plate (32) rotates around the center axis A thereof by the action of a driving means (37), so that the vapor source material (33) carried for example, in the arcuate groove of the holding plate (32), continuously rotates to permit uniform evaporation thereof. The vapor source material (33) can be continuously supplied by the replenishing mechanism (34) to the holding plate (32), as shown in Fig. 11.

Evaporation of the vapor source material (33) may be accomplished by an appropriate means such as resistance heating, induction heating, electron beam (EB) or ion beam irradiation.

In the embodiment shown in Fig. 11, the apparatus is provided with an electron beam irradiating means (35) so that the vapor source material (9) can be evaporated under the effect of a beam from this electron beam irradiating means (35). The evaporated material particles are plasma-excited by means of high-frequency exciting means comprising coil-shaped electrodes (39) while the vapor is controlled by a shutter (38). A film is thereby formed on the substrate (21) with the thus excited ions and radicals.

By causing continuous evaporation of the vapor source material (33) carried on the horizontally rotating holding plate (32), and by arranging the vapor source supply means opposite to each other and substantially perpendicularly to the travelling direction of the substrate (21), it is possible to achieve uniform formation of a film. This is achieved by plasma excitation of vapor particles produced by evaporation and the coil-shaped electrodes, and produces uniform properties of the film structure, film thickness and adhering strength etc. The state of the vapor source material (33) can be observed by means of a quartz monitor or an EIES monitor (40) using exciting source based on electron bombardment.

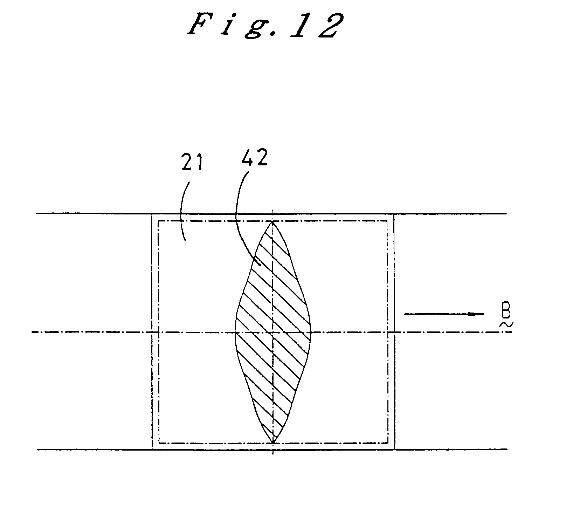

The film is formed during travel of the substrate (21), and the above-mentioned uniformity is maintained in film formation during travel. With a view to further ensuring this uniformity, a film thickness correcting plate (42) is provided in the apparatus of the present invention. This correcting plate (42) is to ensure a uniform film thickness by avoiding overlapping of the excited particles onto the surface of the substrate (21). In the case of this embodiment, as shown in Fig. 12, the correcting plate (42) acts as a partial shield in the travelling direction (B) of the substrate (21). Of course, the shape thereof should preferably be variable in accordance with the shape and arrangement of the vapor source material supply means, the type of vapor source material (33), and the conditions for film formation.

It is desirable to provide a heater (41) so as to permit heating of the substrate (21) from behind, as shown in Fig. 11.

For the vapor deposition section (26), a means for applying bias voltage to the substrate (21) and a supply means of a reactive gas and an inert gas for producing a plasma space are of course appropriately arranged.

High-frequency excited plasma may be produced from the coil-shaped electrodes (39) under conventionally known conditions as described above. Under a vacuum condition of about 2 x 10⁻⁵ to 10⁻³ Torr, for example, a film can be formed by plasma reaction caused by evaporation of a solid material such as a metal, an alloy, an inorganic matter or a polymer through introduction of an inert gas such as argon or helium from the gas introducing mechanism (43) and the introduction of oxygen, nitrogen, hydrogen, and hydrocarbon or polymerizable monomer.

It is possible to form a high-quality ITO (indium-tin oxide) thin film on a glass substrate, for example, at a high productivity by using ITO as the vapor source material and introducing an inert gas or oxygen gas.

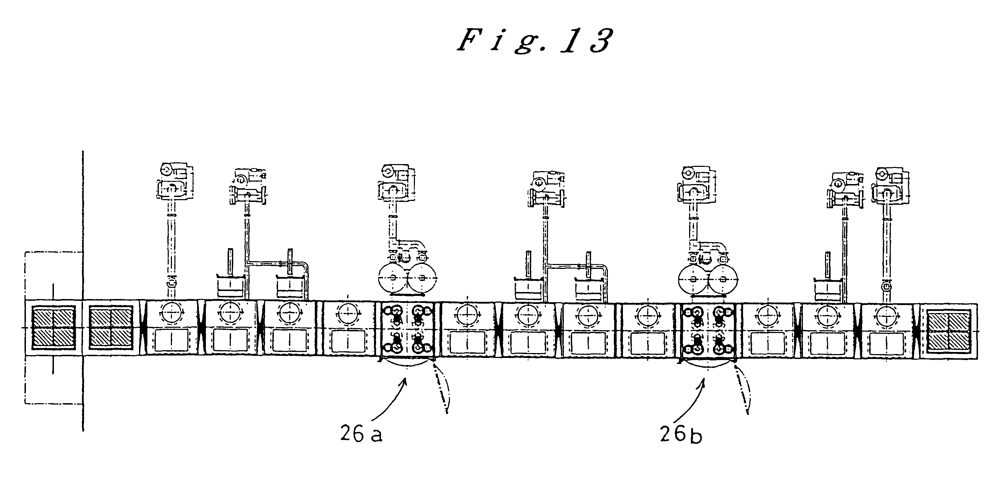

In this embodiment, furthermore, it is possible to form a film of a different substance on a prescribed portion of a masked substrate or a multilayer film by arranging, as shown in Fig. 13, a plurality of vapor deposition sections (26a) and (26b). With the construction as described above, a color filter substrate can, for example, be formed by plasma-vapor-depositing an organic thin film after plasma vapor deposition of a metal or an inorganic material, or a pigment substrate into multiple layers. Formation of a color filter can be continuously associated with formation of an ITO film.

When forming an ITO film (1,500 A) by means of an apparatus having a single vapor deposition section as shown in Figs. 7 to 12, the following configurational specifications should be complied with:
o Film : ITO (1,500 A)
o Effective dimensions for attachment of substrate : 840 mm wide x 930 mm long
o Number of attached substrates : four 400 mm x 450 mm substrates/carrier pallet
o Film thickness distribution : within ± 5%
o Heating of substrate : 250 to 300°C (350°C max.)
o Throughput : minimum cycle time (two minutes)
o Daily production 120 pieces/hr x 24 hr/day = 2,880 pieces/day
o Electric power required for utility : 3-phase, 200 V
   about 220 kVA.
   50/60 Hz.

In the case of the apparatus having two vapor deposition sections (26a)and (25b) as shown in Fig. 13, it is possible to form an ITO multilayer film, or a multilayer film of SiO₂ and ITO.

Of course various other details are possible for the apparatus of the present invention.

As typically represented by the above embodiments of the present invention, the following excellent results are obtainable:
1) By adopting the high-frequency plasma vapor deposition process and permitting continuous supply of the vapor source material, it is possible to form a high-quality film with uniform properties such as structure, film thickness and adherence strength at a lower temperature.
2) As film formation proceeds while the substrate passes continuously above the vapor source material, a very large throughput is available.
3) Continuous film formation of various film materials is possible.
4) It is easier to form a multilayer film by installing a plurality of vapor deposition sections.
5) Continuous supply of the vapor source material permits stable and continuous formation of a film.
6) By providing a return mechanism as a transport means, it suffices to install an inlet-outlet section in the clean room.

## Claims

1. A vacuum plasma vapor deposition apparatus comprising a vapor source supply means (9), a high-frequency exciting means and a substrate holding means arranged above these means, wherein said vapor source supply means has a drive (11) and a circular holding plate (8) connected thereto and rotates horizontally, said circular holding plate being provided with a rotation shaft and a concentric vapor source material carrying section arranged on the surface thereof, **characterised in that** said high-frequency exciting means is provided with coil-shaped electrodes (14), and **in that** a film thickness correcting plate (16) is interposed between said holding plate (8) and said substrate holding means to avoid duplication of excited particles on the surface of a substrate.

2. A vacuum inline plasma vapor deposition apparatus comprising an inlet (2) and an outlet (3) for a substrate at the both ends of the apparatus line, one or more vapor deposition sections (4) permitting independent evacuation to vacuum and evacuation sections (5a,5b) before and after said sections, arranged in series therewith, and a transport means provided in each of the vapor deposition sections and the evacuating sections, allowing continuous passage of the substrate along a path, wherein said apparatus comprises: vapor source material supply means (9) in which at least one vapor deposition section (4) has a rotation shaft on a circular holding plate connected to a drive and rotating horizontally and a section for holding a vapor source material on a concentric surface, a high-frequency exciting means provided with coil-shaped electrodes (14) below the passing substrate, and a film thickness correcting plate (16) is interposed between said holding plate and said path to avoid duplication of excited particles on the surface of the substrate.

3. A plasma vapor deposition apparatus as claimed in claim 1 or 2, wherein said apparatus is provided with a plurality of vapor source supply means (9).

4. A plasma vapor deposition apparatus as claimed in claim 3 wherein a substrate (1) passes through the apparatus along a path and a plurality of vapor source supply means (19) are oppositely arranged at a position substantially at right angles to the direction of said path.

5. A plasma vapor deposition apparatus as claimed in any preceding claim, wherein said vapor deposition section (4) is provided with a substrate heater for heating the substrate passing therein from above.

6. A plasma vapor deposition apparatus as claimed in any preceding claim, wherein at least one of the vacuum evacuating section (5a) acts as a preliminary heating section.

7. A plasma vapor deposition apparatus as claimed in any preceding claim, wherein said film thickness correcting plate (16) provides a shield having a nonuniform width as taken in the direction of said path, said film thickness correcting plate being arranged to inhibit an excess of particles of vapor excited by said high frequency exciting means from accumulating at a given site on the surface of a substrate (1) being transported along said path.

8. A plasma vapor deposition apparatus as claimed in any preceding claim, wherein said concentric vapor source comprises a circular groove in said holding plate.

9. A plasma vapor deposition apparatus as claimed in any preceding claim, further comprising a shutter (13) interposed between said holding plate (8) and said film thickness correcting plate (16), said shutter (13) defining an aperture through which vapor is allowed to pass from said holding plate toward a substrate (1).

10. A processing line comprising inline plasma vapor deposition apparatus as claimed in any of claims 2 to 9, wherein said evacuation sections (5a,5b) are disposed upstream and downstream of said vapor deposition apparatus, said vapor deposition and said evacuation sections including independently evacuatable chambers; said inlet section includes an elevator at one end of said processing line; said outlet section includes an elevator at the other end of said processing line; said transporting means includes a pallet and means for guiding said pallet along a first path through said chambers, the elevators of said inlet and said outlet sections being vertically movable to respective positions aligned with said first path; said apparatus further comprising return means for returning the pallet from said outlet section to said inlet section along a second path disposed above said first path, the elevators of said inlet and said outlet sections also being vertically movable to respective positions aligned with said second path.

## Patentansprüche

1. Vorrichtung zur Plasmavakuumbedampfung mit einem Verdampferquellenversorgungsmittel (9), einem Hochfrequenzanregungsmittel und einem oberhalb dieser Mittel angeordneten Substrathaltemittel, wobei das Verdampferquellenversorgungsmittel einen Antrieb (11) und eine damit verbundene und horizontal rotierende kreisförmige Halteplatte (8) aufweist, und wobei die kreisförmige Halteplatte mit einer Drehwelle und einem auf deren Oberfläche angeordneten konzentrischen Abschnitt zum Tragen von Verdampferquellenmaterial versehen ist, **dadurch gekennzeichnet, daß** das Hochfrequenzanregungsmittel mit spulenförmigen Elektroden (14) versehen ist und daß eine Filmdickenkorrekturplatte (16) zum Vermeiden einer Verdoppelung von angeregten Partikeln auf der Oberfläche eines Substrats zwischen der Halteplatte (8) und dem Substrathaltemittel angeordnet ist.

2. Vorrichtung zur Plasmavakuumfertigungsbedampfung mit einem Einlaß (2) und einem Auslaß (3) für ein Substrat an beiden Enden der Fertigungslinie, einem oder mehreren Bedampfungsabschnitten (4), die eine unabhängige Evakuierung zum Vakuum gestatten, und mit Evakuierungsabschnitten (5a,5b) vor und hinter den Abschnitten und in Reihe dazu angeordnet, und einem in jedem der Bedampfungsabschnitte und der Evakuiertungsabschnitte vorgesehenen Transportmittel, das einen kontinuierlichen Durchlauf des Substrats entlang eines Pfades gestattet, wobei die Vorrichtung folgendes umfaßt: ein Verdampferquellenmaterialversorgungsmittel (9), in dem mindestens ein Bedampfungsabschnitt (4) eine Drehwelle auf einer kreisförmigen Halteplatte aufweist, die mit einem Antrieb verbunden ist und horizontal rotiert, und einen Abschnitt zum Halten eines Verdampferquellenmaterials auf einer konzentrischen Oberfläche, ein Hochfrequenzanregungsmittel, das mit spulenförmigen Elektroden (14) unterhalb des vorbeilaufenden Substrats ausgestattet ist, und einer Filmdickenkorrekturplatte (16), die zwischen der Halteplatte und dem Pfad angeordnet ist, um eine Verdoppelung von angeregten Partikeln auf der Oberfläche des Substrats zu vermeiden.

3. Vorrichtung zur Plasmabedampfung nach Anspruch 1 oder 2, bei der die Vorrichtung mit einer Mehrzahl von Verdampferquellenversorgungsmitteln (9) ausgestattet ist.

4. Vorrichtung zur Plasmabedampfung nach Anspruch 3, bei der ein Substrat (1) entlang eines Pfads durch die Vorrichtung läuft und eine Mehrzahl von Verdampferquellenversorgungsmitteln (19) gegenüberliegend in einer zu der Richtung des Pfades im wesentlichen rechtwinkligen Position angeordnet sind.

5. Vorrichtung zur Plasmabedampfung nach einem der vorstehenden Ansprüche, bei der der Bedampfungsabschnitt (4) mit einem Substratheizer zum Heizen des durch den Abschnitt laufenden Substrats von oben versehen ist.

6. Vorrichtung zur Plasmabedampfung nach einem der vorstehenden Ansprüche, bei der mindestens einer der Vakuumevakuierungsabschnitte (5a) als vorläufiger Heizungsabschnitt dient.

7. Vorrichtung zur Plasmbedampfung nach einem der vorstehenden Ansprüche, bei der die Filmdickenkorrekturplatte (16) ein Schild mit nicht-gleichförmiger Breite hinsichtlich der Richtung des Pfades bereitstellt, wobei die Filmdickenkorrekturplatte dazu angeordnet ist, einen Überschuß an durch das Hochfrequenzanregungsmittel angeregten Dampfpartikeln daran zu hindern, sich an einem gegebenen Platz auf der Fläche des entlang des Pfads transportierten Substrats (1) anzusammeln.

8. Vorrichtung zur Plasmabedampfung nach einem der vorstehenden Ansprüche, bei der die konzentrische Verdampferquelle eine kreisförmige Nut in der Halteplatte umfaßt.

9. Vorrichtung zur Plasmabedampfung nach einem der vorstehenden Ansprüche, die des weiteren eine zwischen der Halteplatte (8) und der Filmdickenkorrekturplatte (16) angeordnete Klappe (13) aufweist, die eine Apertur bzw. Öffnung definiert, durch die Dampf von der Halteplatte in Richtung des Substrats (1) hindurchgelangen darf.

10. Fertigungslinie mit einer Vorrichtung zur Plasmavakuumfertigungsbedampfung gemäß einem der Ansprüche 2 bis 9, wobei die Evakuierungsabschnitte (5a,5b) stromaufwärts und -abwärts der Bedampfungsvorrichtung angeordnet sind und die Bedampfungsabschnitte und Evakuierungsabschnitte unabhängig voneinander evakuierbare Kammern umfassen, wobei der Einlaßabschnitt an einem Ende der Fertigungslinie einen Aufzug umfaßt, wobei der Auslaßabschnitt am anderen Ende der Fertigungslinie einen Aufzug umfaßt, wobei das Transportmittel eine Palette und Mittel zum Führen der Palette entlang eines ersten Pfades durch die Kammern umfaßt, wobei die Aufzüge des Einlaß- und des Auslaßabschnitts vertikal in jeweils mit dem ersten Pfad ausgerichtete Positionen bewegbar sind, wobei die Vorrichtung des weiteren Rücksendemittel zum Zurücksenden der Palette von dem Auslaßabschnitt zu dem Einlaßabschnitt entlang eines oberhalb des ersten Pfades angeordneten zweiten Pfades umfaßt und die Aufzüge des Einlaß- und des Auslaßabschnittes auch in jeweilige Positionen, die mit dem zweiten Pfad ausgerichtet sind, vertikal bewegbar sind.

## Revendications

1. Dispositif de dépôt en phase vapeur sous plasma sous vide comprenant un moyen d'alimentation de source de vapeur (9), un moyen d'excitation à haute fréquence et un moyen de support de substrat agencé au-dessus des précédents moyens, dans lequel ledit moyen d'alimentation de source de vapeur comporte un dispositif d'entraînement (11) et une plaque de support circulaire (8) reliée à celui-ci et tournant horizontalement, ladite plaque de support circulaire comportant un arbre tournant et une section de support de matériau formant source de vapeur concentrique agencée sur sa surface, **caractérisé en ce que** ledit moyen d'excitation à haute fréquence comporte des électrodes en forme de bobine (14), et **en ce qu'**une plaque de correction d'épaisseur de film (16) est interposée entre ladite plaque de support (8) et ledit moyen de support de substrat de manière à éviter la duplication de particules excitées sur la surface du substrat.

2. Dispositif de dépôt en phase vapeur sous plasma en continu sous vide comprenant une entrée (2) et une sortie (3) pour un substrat aux deux extrémités de la ligne de dispositif, une ou plusieurs sections de dépôt en phase vapeur (4) permettant une mise sous vide indépendante et des sections de mise sous vide (5a et 5b) avant et après lesdites sections, agencées en série avec celles-ci, et un moyen de transfert placé dans chacune des sections de dépôt en phase vapeur et des sections de mise sous vide, permettant un passage continu du substrat le long d'un trajet, dans lequel ledit dispositif comprend: un moyen d'alimentation de matériau de source de vapeur (9) dans lequel au moins une section de dépôt en phase vapeur (4) comporte un arbre tournant sur une plaque de support circulaire raccordée à un dispositif d'entraînement et tournant horizontalement et une section destinée à supporter un matériau de source de vapeur sur une surface concentrique, un moyen d'excitation à haute fréquence comportant des électrodes en forme de bobine (14) au-dessous du substrat en déplacement, et une plaque de correction d'épaisseur de film (16) est interposée entre ladite plaque de support et ledit trajet de manière à éviter la duplication de particules excitées sur la surface du substrat.

3. Dispositif de dépôt en phase vapeur sous plasma selon la revendication 1 ou 2, dans lequel ledit dispositif comporte une pluralité de moyens d'alimentation de source de vapeur (9).

4. Dispositif de dépôt en phase vapeur sous plasma selon la revendication 3, dans lequel un substrat (1) passe à travers le dispositif suivant un certain trajet et une pluralité de moyens d'alimentation de source de vapeur (19) est agencée à l'opposé d'un emplacement sensiblement à angle droit par rapport à la direction dudit trajet.

5. Dispositif de dépôt en phase vapeur sous plasma selon l'une quelconque des revendications précédentes, dans lequel ladite section de dépôt en phase vapeur (4) comporte un dispositif de chauffage de substrat destiné à chauffer le substrat passant à l'intérieur, par le dessous.

6. Dispositif de dépôt en phase vapeur sous plasma selon l'une quelconque des revendications précédentes, dans lequel au moins une des sections de mise sous vide (5a) sert de section de chauffage préalable.

7. Dispositif de dépôt en phase vapeur sous plasma selon l'une quelconque des revendications précédentes, dans lequel ladite plaque de correction d'épaisseur de film (16) forme un écran présentant une largeur non uniforme prise dans la direction dudit trajet, ladite plaque de correction d'épaisseur de film étant agencée de manière à empêcher qu'un excès de particules de vapeur excitées par ledit moyen d'excitation à haute fréquence s'accumule sur un site donné sur la surface d'un substrat (1) se déplaçant le long dudit trajet.

8. Dispositif de dépôt en phase vapeur sous plasma selon l'une quelconque des revendications précédentes, dans lequel ladite source de vapeur concentrique comprend une rainure circulaire dans ladite plaque de support.

9. Dispositif de dépôt en phase vapeur sous plasma selon l'une quelconque des revendications précédentes, comprenant, en outre, un obturateur (13) interposé entre ladite plaque de support (8) et ladite plaque de correction d'épaisseur de film (16), ledit obturateur (13) définissant une ouverture à travers laquelle la vapeur peut passer depuis ladite plaque de support vers un substrat (1).

10. Ligne de traitement comprenant un dispositif de dépôt en phase vapeur sous plasma en continu selon l'une quelconque des revendications 2 à 9, dans laquelle lesdites sections de mise sous vide (5a, 5b) sont disposées en amont et en aval dudit dispositif de dépôt en phase vapeur, ladite section de dépôt en phase vapeur et lesdites sections de mise sous vide comprenant des chambres pouvant être mises sous vide de manière indépendante ; ladite section d'entrée comprend un élévateur à une extrémité de ladite ligne de traitement ; ladite section de sortie comprend un élévateur à l'autre extrémité de ladite ligne de traitement ; ledit moyen de transfert comprend une palette et des moyens de guidage de ladite palette le long d'un premier trajet à travers lesdites chambres, les élévateurs de ladite section d'entrée et de ladite section de sortie étant mobiles verticalement vers des positions respectives alignées avec ledit premier trajet ; ledit dispositif comprenant, en outre, un moyen de retour destiné à renvoyer la palette depuis ladite section de sortie vers ladite section d'entrée le long d'un second trajet disposé au-dessus dudit premier trajet, les élévateurs desdites section d'entrée et de sortie étant aussi mobiles verticalement vers des positions respectives alignées avec ledit second trajet.
